Europäisches Patentamt

European Patent Office

Office européen des brevets

(11) Publication number: **0 506 969 A1**

## EUROPEAN PATENT APPLICATION
### published in accordance with Art. 158(3) EPC

(21) Application number: **91917701.4**

(22) Date of filing: **15.10.91**

(86) International application number:
**PCT/JP91/01398**

(87) International publication number:
**WO 92/07383 (30.04.92 92/10)**

(51) Int. Cl.⁵: **H01L 27/115**

(30) Priority: **22.10.90 JP 284059/90**

(43) Date of publication of application:
**07.10.92 Bulletin 92/41**

(84) Designated Contracting States:
**DE FR GB IT NL**

(71) Applicant: **SEIKO EPSON CORPORATION**
**4-1, Nishishinjuku 2-chome**
**Shinjuku-ku Tokyo 163(JP)**

(72) Inventor: **KATO, Koji, 3-5, Owa 3-chome**
**Suwa-shi**
**Nagano-ken 392(JP)**

(74) Representative: **Ouinterno, Giuseppe et al**
**c/o Jacobacci-Casetta & Perani S.p.A. Via**
**Alfieri, 17**
**I-10121 Torino(IT)**

(54) **SEMICONDUCTOR DEVICE.**

(57) A semiconductor storing device using ferroelectric substances in which, by forming an oxygen-nonpermeable conductive film (107) between a semiconductor substrate (101) and a ferroelectric capacitor, oxygen is prevented from diffusing in subsequent heat treatment processes in oxidation atmosphere, and the characteristics of the elements located under the oxygen-nonpermeable film can be prevented from deteriorating by oxygen.

Fig. 1(a)

## FIELD OF THE INVENTION

The present invention relates to a structure of a semiconductor memory device using a ferroelectric material.

## BACKGROUND OF THE INVENTION

MIS transistors are usually used as a conventional semiconductor nonvolatile memory which make use of a phenomenon that the surface potential of a silicon substrate can be modified through the injection of charge from the silicon substrate into an insulating gate trap or a floating gate, and are practically used as an EPROM (ultra-violet ray erasing type nonvolatile memory) and an EEPROM (electrically rewritable nonvolatile memory). These nonvolatile memories, however, have disadvantages in that an information re-writing voltage is usually as high as about 20 V and the re-writing time is extremely long (for instance, several tens of msec. in the case of the EEPROM). In addition, the information re-writing number is very small, typically about 100 times, thus posing problems in cases of repeated use.

With a nonvolatile memory using a ferroelectric material capable of electrically inverting polarization, the writing-in and reading-out times are substantially the same in principle, and also the polarization is maintained even if the power source is disconnected. Thus, the memory is possibly an ideal nonvolatile memory. As such a nonvolatile memory using a ferroelectric material, there has been proposed a structure in which a ferroelectric capacitor is integrated on a silicon substrate as shown in United States Patent No. 4,149,302, and a nonvolatile memory which has a ferroelectric film provided on a gate portion of a MIS transistor as shown in United States Patent No. 3,832,700. Further, recently a nonvolatile memory having a laminate structure of a MOS semiconductor device as shown in Fig. 2 has been proposed in the IEDM, '87 pp, 850-851.

In Fig. 2, a reference numeral 201 designates a P-type Si substrate, 202 a LOCOS oxide film for isolation, 203 an N-type diffusion layer constituting a source and 204 an N-type diffusion layer constituting a drain. A reference numeral 205 illustrates a gate electrode, and 206 an interlayer insulation film. Designated at a reference numeral 207 is a ferroelectric film, which constitutes a capacitor together with electrodes 208 and 209 having the ferroelectric film therebetween. A reference numeral 210 illustrates a second insulation film and 211 designates A1 constituting a lead electrode. Thus, with such a structure wherein the ferroelectric film is stacked on the upper portion of the MOS semiconductor substrate device, there has arisen such a problem that during the heat or thermal treatment of the structure in an oxygen atmosphere, oxygen diffuses into a semiconductor element to thereby degrade or deteriorate the characteristics or properties of the element.

Then, the present invention seeks to solve this problem, and its object is to provide an excellent semiconductor device by inhibiting the oxygen diffusion into the semiconductor device and preventing the property of the element from deterioration thereof.

## DISCLOSURE OF THE INVENTION

A semiconductor device in which at least one capacitor using a ferroelectric substance or material is integrated on one and the same semiconductor substrate having formed thereat at least one active element, which is characterized in that a conductive, oxygen-impermeable film is included as one of layers between the semiconductor substrate and the capacitor, and the layer of the conductive, oxygen-impermeable film is isolated from an interlayer insulation film by another film.

## BRIEF DESCRIPTION OF THE DRAWINGS

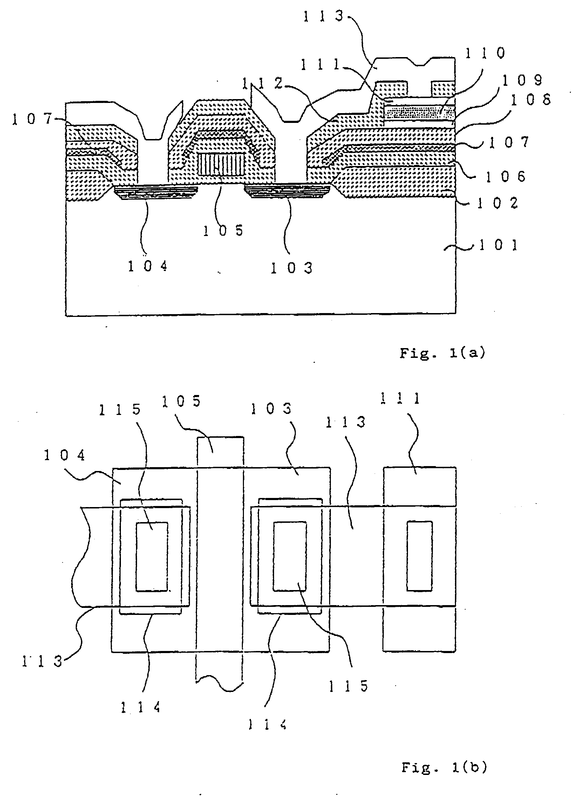

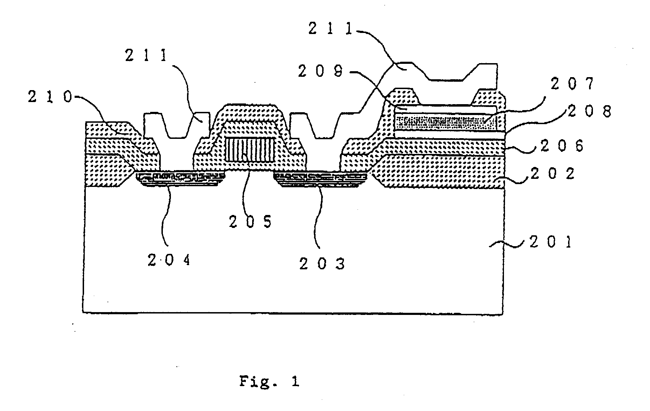

Fig. 1(a) is a main sectional view showing a semiconductor device according to an embodiment of the present invention. Fig. 1(b) is a main plane view showing the semiconductor device according to the embodiment of the present invention. Fig. 2 is a main sectional view showing a semiconductor memory device according to the conventional technique.

## BEST MODE FOR CARRYING OUT THE INVENTION

Fig. 1(a) is a main plane view showing one embodiment of a semiconductor device of the present invention. A semiconductor device of the present invention will hereinafter be explained with reference to Fig. 1. Here, for the sake of brevity, the explanation will be given as an example, in which a Si substrate and an N-channel transistor are used. (Fig. 1(a))

A reference numeral 101 designates a P-type Si substrate, which may, for example, be a wafer with a resistivity of 20 Ohm $\cdot$ cm. A reference numeral 102 designates an insulation film for isolation, which is formed of an oxide film to a thickness of 6000 Å by using the conventional LOCOS method. A reference numeral 103 designates an N-type diffusion layer intended to form a source and is formed by, for example, ion implantation of phosphorous with a condition of 80 KeV and $5 \times 10^{15}$ $cm^{-2}$. A reference numeral 104 designates an N-type diffusion layer intended to form a drain of the MOS transistor and formed simultaneously with 103. A reference numeral 105 shows a gate electrode which is formed, for example, of a phosphorus doped poly-silicon. A reference numeral 106 shows an interlayer insulation film which is formed, for example, of phosphorus glass to a thickness of 4000 Å by using a CVD method.

A reference numeral 107 illustrates a conductive, oxygen-impermeable film according to the gist of the present invention. The film is formed, for example, of titanium nitride with a thickness of 1000 Å by using a sputtering method in an oxygen atmosphere. Thereafter, by using the photolithographic method, opening 114 is opened through the conductive, oxygen impermeable film 107 at its portions where the connections are intended to be formed between the high impurity concentration layers 103, 104, etc., as well as the gate electrode 105, etc., and a wiring or interconnection layer positioned thereabove. Here, attention should be paid to the following point. Namely, it is necessary to make the openings 114 larger than that of contacting holes 115 in order to prevent the conductive, oxygen impermeable film 107 from exposing at the side walls of the contacting holes 115 through which the regions 103, 104, 105, etc. and the upper wiring layer are intended to be connected to each other. Next, silicon oxide is formed as a second interlayer insulation film with a thickness of 1500 Å by using the chemical vapor deposition technique.

A reference numeral 108 designates one of the electrodes sandwiching the ferroelectric substance and formed to a thickness of 1000 Å, for example, by the sputtering of Pt. A reference numeral 107 illustrates a ferroelectric film, which is formed of, for example, $PbTiO_3$ to a thickness of 2000 Å by the sputtering method and then sintered in the oxygen atmosphere at a temperature of 700 °C. A reference numeral 109 shows the other one of the electrodes sandwiching the ferroelectric film, the electrode being formed as the same way as the electrode 108. A reference numeral 110 shows the third interlayer insulation film. The film has provided therethrough the contact holes 115 formed by using the conventional photo-etching technique after forming the film of phosphorus glass to a thickness of 4000 Å by using, for example, the chemical vapor deposition method. At this time, attention should be paid to the following point. It is required that the holes 115 should be formed inside the openings 114 as shown in Fig. 1(b) so as not to expose the conductive, oxygen impermeable film 107 at the side walls of the contact holes 115.

A reference numeral 112 shows a wiring or interconnecting electrode, which is formed of, for example, aluminum to a thickness of 5000 Å by the sputtering method and formed in a shape of a predetermined pattern.

According to the above-mentioned process, a structure of the present embodiment can be obtained.

With such structure, the oxygen diffusion into the substrate will be inhibited during the thermal treatment in the oxygen atmosphere carried out after the forming of the oxygen impermeable film 107, and, in addition, the short-circuit caused by the conductivity of the oxygen impermeable film 107 will be avoided by adopting the formation of contact holes 115 inside of the openings 114 bored through the oxygen impermeable film 107.

A structure having omitted the oxygen impermeable film 107 in such structure as shown in Fig. 1(a) was subjected to the thermal treatment in an oxygen at a temperature of 700 °C when sintering lead titanate. Then, an off-leak current of about $10^{-7}$ A of the N type MOS transistor was attained at a drain voltage of 5 V. In contrast, when carrying out the similar heat treatment to the structure of the present embodiment, the off-leak current of about $10^{-11}$ A was attained.

APPLICABILITY IN THE INDUSTRY

According to the present invention, a conductive, oxygen impermeable film is formed on a semiconductor substrate at which at least one active element is formed. Therefore, effects are obtained such that, during the thermal treatment in the oxidizing atmosphere at later steps, the oxygen diffusion into the semiconductor substrate is inhibited to thereby prevent the properties or characteristics of the element from deterioration thereof.

**Claims**

1. A semiconductor device in which at least one capacitor having a ferroelectric substance is integrated on one and the same semiconductor substrate having formed thereat at least one active element, which is characterized in that

    layers between the semiconductor substrate and the capacitor include a conductive, oxygen impermeable film.

2. A semiconductor device as claimed in claim (1), which is characterized in that the layer of the conductive, oxygen impermeable film is isolated from other layers by an interlayer insulation film.

3. A semiconductor device as claimed in claims (1) or (2), which is characterized in that

    at a contact hole portion where the semiconductor substrate is to be connected to a wiring layer above the conductive, oxygen impermeable film, a contact hole through which the wiring layer and the semiconductor substrate is to be connected and which is bored through the interlayer insulation film is positioned inside a hole which is opened through the conductive, oxygen impermeable film.

4. A semiconductor device as claimed in claim (1), which is characterized in that the conductive, oxygen impermeable film comprises as a main component one of material selected from the group of TiN, TiW, MoSi, TiN being subjected to the oxygen treatment and TiON.

**Amended Claims**

1. A semiconductor device comprising:
   a substrate having at least one active element formed therein;
   a capacitors disposed over said substrate;
   an oxygen impermeable film disposed between said substrate and said capacitor;
   a first insulation layer under said oxygen impermeable film; and
   a second insulation layer over said oxygen impermeable film, said second insulation layer contacting said first insulation layer where said oxygen impermeable film has been removed.

2. A device according to Claim 1 further comprising: at least one opening in said oxygen impermeable film; and at least one contact hole etched in said first and second insulation layers and disposed within said at least one opening.

3. A device according to Claim 2 wherein said oxygen impermeable film is isolated from said at least one contact hole by said second insulation layer.

4. A device according to Claim 1 wherein said oxygen impermeable film comprises a film selected from a group comprising TiN, TiW, MoSi, oxygen treated TiN and TiON.

5. A method for fabricating a semiconductor device comprising the steps of:
   establishing an active element in a substrate;
   establishing a first insulation layer over said active element;
   establishing an oxygen impermeable film over said first insulation layer;
   etching at least one opening in said oxygen impermeable film;
   establishing a second insulation layer over said oxygen impermeable film and in said at least one opening;
   etching a contact hole in said first and second insulation layers, and within said at least one opening, such that said second insulation layer isolates said oxygen impermeable film from said contact hole.

Fig. 1(a)

Fig. 1(b)

Fig. 1

# INTERNATIONAL SEARCH REPORT

International Application No PCT/JP91/01398

## I. CLASSIFICATION OF SUBJECT MATTER (if several classification symbols apply, indicate all) 6

According to International Patent Classification (IPC) or to both National Classification and IPC

Int. Cl$^5$ H01L27/115

## II. FIELDS SEARCHED

| Minimum Documentation Searched 7 | |
|---|---|
| Classification System | Classification Symbols |
| IPC | H01L27/115, 29/792 |

Documentation Searched other than Minimum Documentation
to the Extent that such Documents are Included in the Fields Searched 8

Jitsuyo Shinan Koho      1964 - 1990
Kokai Jitsuyo Shinan Koho      1973 - 1990

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| Y | JP, A, 2-183569 (Seiko Epson Corp.), July 18, 1990 (18. 07. 90) | 1 |
| Y | JP, A, 62-188223 (Sony Corp.), August 17, 1987 (17. 08. 87), (Family: none) | 4 |
| A | JP, A, 1-253257 (Fuji Electric Co., Ltd.), October 9, 1989 (09. 10. 89) | 1, 4 |
| A | JP, A, 58-197764 (Hitachi, Ltd.), November 17, 1983 (17. 11. 83) | 2, 3 |

* Special categories of cited documents: 10
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step
"Y" document of particular relevance; the claimed invention cannot be considered to involve an inventive step when the document is combined with one or more other such documents, such combination being obvious to a person skilled in the art
"&" document member of the same patent family

## IV. CERTIFICATION

| Date of the Actual Completion of the International Search | Date of Mailing of this International Search Report |
|---|---|
| January 6, 1992 (06. 01. 92) | January 21, 1992 (21. 01. 92) |
| International Searching Authority | Signature of Authorized Officer |
| Japanese Patent Office | |

Form PCT/ISA/210 (second sheet) (January 1985)